# EUROPEAN PATENT SPECIFICATION

(11) **EP 2 925 100 B1**
(45) Date of publication and mention of the grant of the patent: **09.02.2022**
(21) Application number: 15156471.3
(22) Date of filing: 25.02.2015
(51) Int. Cl.: B32B 37/12, B32B 27/10, B32B 37/26, B32B 7/12, B32B 7/14, B32B 17/10, B32B 27/08, B32B 27/30, B32B 7/06

(54) **Busbars**
Sammelschienen
Barres omnibus

(30) Priority: 27.03.2014 GB 201405495
(43) Date of publication of application: 30.09.2015
(73) Proprietor: Strip Tinning Limited, West Midlands B45 0JA (GB)
(72) Inventor: Barton, Richard, Rugeley, Staffordshire WS15 1QQ (GB); Wong, Simon, Birmingham, West Midlands B45 0JA (GB); Holmes, Christopher, Birmingham, West Midlands B45 0JA (GB); O'Connor, Stephen, Solihull, West Midlands B91 1LR (GB)
(74) Representative: HGF

(56) References cited:
- EP-A1- 0 278 611
- WO-A1-96/01605
- CA-A1- 2 879 446
- US-A1- 2003 146 199
- US-A1- 2013 048 336

## Description

This invention relates to busbars, specifically, although not exclusively, to busbars usable in heated windscreens.

A busbar is typically used to provide electrical contact between a source of electrical energy and plural circuits in an electrical apparatus or system. Hence, they are formed of electrically conductive material and are typically provided as strips or tubes. It is usual to use a strip or tube shape because of those shape's inherent heat dissipation efficiency. Busbars may be electrically isolated by use of covering insulators or by use of earthed enclosures. In many cases a busbar is used for electrical conduction and not for performing a structural function.

It is known to provide as a busbar a copper strip which has been coated with tin.

Other proposals provide busbars which are absent a tin protective coating. For example, US2013/0048336 describes a busbar for use with photovoltaic cells in which, instead of a tin coating, a copper strip is coated with a polymeric coating on one major surface and a conductive adhesive layer on another major surface, with the aim of reducing the cost of the coated busbar. In the absence of a tin coating, and in order to prevent oxidation of the copper strip, the polymeric coating and adhesive layer has to be applied across the entirety of each major surface of said copper strip. A combined busbar and electrical lead and methods of forming the same are described in EP0278611. A method of manufacturing sheets with a protective coating is described in WO 96/01605.

Busbars which are deployed between panes of glass to facilitate electrical connection to one or more resistively heatable wires or filaments (the heating element) in a heated windscreen are preferably thin. Because the busbar is thin it does not cause or generate air gaps between the facing panes of glass, which could lead to failure of the heating element. The tin coating protects the underlying copper from oxidising or otherwise reacting, for example with or in the presence of ingressing water.

Whilst such busbars are capable of providing the necessary electrical connectivity there is a desire to provide a busbar which has or incorporates means to secure it in place within a structure. Moreover, it is also desired to provide a busbar which has a known and/or constant amount of securing means and/or securing means which is accurately located on the busbar. It is also desired to provide a busbar which can be easily located in use by a skilled or less skilled installer.

It is an object of the current invention to satisfy at least one of the issues aforementioned.

Accordingly, in a first aspect of the invention there is provided a continuous method of forming a busbar in accordance with Claim 1.

Preferably the conductive material comprises an electrically conductive substrate provided with a protective coating. The protective coating will usually protect the electrically conductive material from environmental degradation (e.g. oxidation and/or other chemical or physical damage)

The adhesive material may be dimensionally invariant.

The adhesive material may be secured to the conductive material through the application of heat and/or pressure.

In a second aspect of the invention there is provided a busbar for installation on or in a structure in accordance with Claim 6.

The adhesive material is inboard of both of the elongate edges of the conductive material. There is an adhesive material free border at edges of the conductive material. This is advantageous because, in use, adhesive will not ball or otherwise become inhomogeneously distributed or protrude beyond the edge of the conductive material which can lead to air gaps or other irregularities when the busbar is installed at a site of use. Whilst securing adhesive to only a portion of a surface of the busbar does not afford optimum adhesion (because the available area of adhesive is less than the area of the major surface of the busbar) we have surprisingly found it significantly improves the characteristics during and after installation.

The electrically conductive material may be dimensionally invariant.

In this specification, the term dimensionally invariant means a material which has a constant cross section in a longitudinal direction, and constant in this context means that the cross sectional area varies by less than 15%, preferably equal to or less than 10%, preferably equal or less than 9, 8, 7, 6 or 5% along a 1mm longitudinal portion, for example along a 2, 3, 4, 5, 6, 7, 8, 9, 10mm longitudinal portion. In one embodiment, the bus bar is 5, 10 or 15cm long and the cross sectional area of both the electrically conductive material and/or the adhesive material varies by 5% or less along the entire length. Also in this specification an adhesive is a material which is selected from a reactive or non-reactive adhesive, preferably a non-reactive adhesive selected from a contact adhesive, pressure-sensitive adhesive, hot adhesive and drying adhesive but excludes solders, solder pastes and the like.

The electrically conductive material is preferably elongate. In one embodiment the material is in strip form, *i.e.* it has a length and width dimension significantly larger than its thickness dimension. For example, the material's width dimension can be over 50, say over 60, 70, 80, 90, 100 times its thickness dimension.

The electrically conductive material may be in strip form having a width of from 3 to 15 mm, say from 4 to 14mm, for example from 5 to 10mm. In one embodiment the strip may be about 6 mm wide, in another embodiment the strip may be 8mm wide. The variation of width is preferably tightly controlled, for example less than 10%, say less 9, 8, 7, 6, 5, 4, 3, 2% in a longitudinal direction. The electrically conductive material may have a thickness of from 10 to 120 or 100 microns, say from 15 or 30 to 100 or 90 microns. The variation of thickness is preferably tightly controlled, say less than 15%, preferably less than 14, 13, 12, 11, 10, 9, 8, 7 or 6%, e.g. from 1-5%.

The electrically conductive material is preferably formed from copper. The electrically conductive material may comprise, for example be formed of, for example, a substrate, say a metal substrate (e.g. copper) coated with a protective coating, for example tin or tin alloy, or a polymeric coating. The protective coating may be equal to or less than 10 microns (*i.e.* ≤10⁻⁵m) thick, for example 9, 8, 7, 6, 5, 4, 3, 2, 1 microns thick. Preferably the protective coating is from 0.25 to 7, say 0.5 to 5 microns thick, for example from 1 to 4 microns thick.

The adhesive material preferably comprises a carrier substrate with a pair of major surfaces, each of which may carry adhesive. Preferably the adhesive material has two faces, each carrying adhesive or being adherent. The adhesive may be a pressure sensitive adhesive. The adhesive may be an acrylic adhesive.

The adhesive material may be electrically conductive or non-electrically conductive. The electrically conductive adhesive material may be conductive in one or two planes but not a third, or in one plane but not the other two, or in all three planes. If the adhesive material is electrically conductive it may comprise an adhesive matrix in combination with electrically conductive particles. Preferably, the particles are provided such that the tape is electrically conductive in one plane, or two panes but not the other two or one respectively.

In one embodiment the electrically conductive adhesive material is provided as a flat tape, and which is electrically conductive in one plane, preferably the Z-direction in the thickness direction of the tape and not in the X and Y directions, in the plane of the tape.

The adhesive material will preferably be located about a centre line of the conductive material.

Preferably the adhesive material will cover more than 25% of the surface area of one side of the conductive material, for example more than, 30, 35, 35, 40, 45, 50, 55, 60, 65, 70, 75, 80, 85, 90, 95% of the surface area of the conductive material.

Where the conductive material is flat, having a major surface to which the adhesive material is applied, the adhesive material may be located at the longitudinal centre line of the major surface, preferably with a tolerance of less than 1 mm, for example less than 0.9, 0.8, 0.7, 0.6 or 0.5mm.

It is advantageous that the adhesive material is applied with a high tolerance in respect of the amount applied and/or in respect of the desired location on the conductive material. It is beneficial that the accuracy and/or precision of application is high. It is advantageous that a major proportion of the surface area of the conductive material is covered so as to aid installation of the busbar.

The adhesive material is preferably provided with a release liner, *e.g.* a siliconised release liner such as siliconised paper, *e.g.* kraft paper.

The adhesive is preferably equal to or less than 150 µm (*i.e.* ≤1.5 × 10⁻⁴m) thick. For example the adhesive may be from 10 to 150µm, say less than 100, 95, 90, 85, 80, 75, 70, 65, 60 or 55 µm thick.

A third aspect of the invention provides apparatus for continuously forming a busbar in accordance with Claim 14.

One of the advantages of the method of the invention is that it allows dimensionally invariant busbar materials to be produced in a clean and controlled manner.

In a preferred embodiment the conductive material and/or adhesive material is/are supplied from a and/or respective reels and/or the busbar is delivered to a reel.

In one embodiment, adhesive material is supplied from an adhesive supply reel. The adhesive provided on the adhesive supply reel is preferably biased into contact with an alignment reel. It has been found that biasing the adhesive on the adhesive supply reel into contact with the alignment reel greatly improves the control of the adhesive upon application to the conductive material.

In order that the invention may be more fully understood it will now be described, by way of example only, with reference to the accompanying drawings, in which:
Figure 1A is a diagrammatic perspective view of a first busbar according to the invention;
Figure 1B is a diagrammatic cross sectional view of the busbar of Figure 1A;
Figure 2 is a schematic view of apparatus according to the invention; and
Figure 3A is a diagrammatic perspective view of a second busbar according to the invention; and
Figure 3B is a diagrammatic cross sectional view of the busbar of Figure 3A.

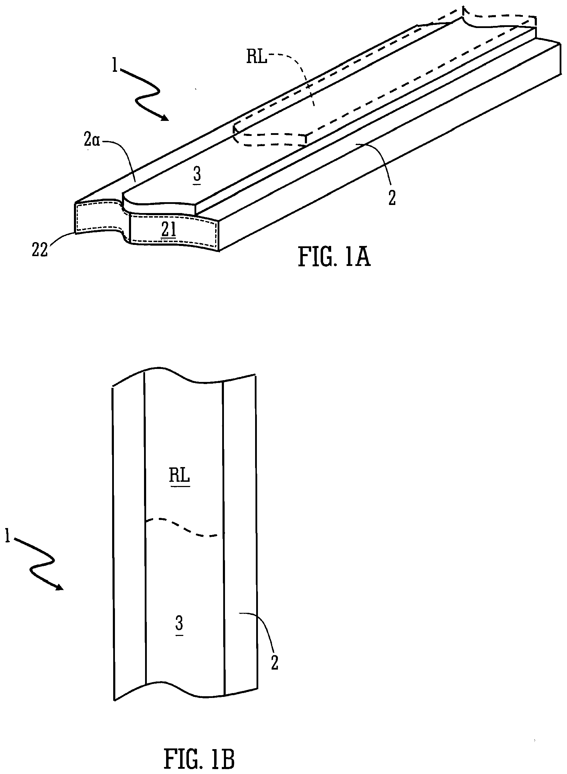

Referring to Figures 1A and 1B, there is shown a busbar 1. The busbar 1 comprises a substrate of coated copper 2 with a length of adhesive material 3 secured thereto. The adhesive material 3 is a strip of adhesive and has a rectangular configuration.

In brief, the substrate of coated copper 2 comprises a rectangular copper strip 21, typically provided with dimensions 8 × 0.5 mm or 6 × 0.5 mm or 4 × 0.5mm, which is coated with a very thin (*e.g.* from 1 to 4 micron) tin layer 22. Typically the tin layer 22 is provided by electroplating, but may also be provided by dip-coating, spraying, painting and so on.

To one major surface 2a of the substrate 2 is secured a length of adhesive material 3, which preferably comprises an acrylic adhesive. The adhesive material 3 is preferably secured to the substrate 2 by localised pressure and/or heating as shall be explained in more detail below. The adhesive layer 3 may be protected by an optional release liner RL. The adhesive is preferably applied at and about a mid-point of the first major surface 2a and terminates inboard of the edges of the substrate 2, preferably by more than 0.5mm.

The characteristics of the so-formed busbar 1 are as follows:

**Table 1. Material Characteristics**

| **Substrate** | | Material | Cu (C101) |
|---|---|---|---|
| | | Dimensions (a) | 8.0±0.4mm × 0.05mm±0.5% |
| | | Dimensions (b) | 6.0±0.3mm × 0.05mm±0.5% |
| | | Dimensions (c) | 4.0±0.2mm × 0.05mm±0.5% |
| | Coating | Material | Sn ≥ 99.95% |
| | | Thickness | 2.5µm ± 1.5 µm |

| **Adhesive (A)** | | Material | Acrylic adhesive |
|---|---|---|---|
| | | Thickness | 50µm |
| | | Adhesion | 350cN/20mm |
| | | Dimensions (a) | 6.0mm |
| | | Dimensions (b) | 4.0mm |
| | | Dimensions (c) | 3.0mm |
| | Release Liner | Material Thickness | Siliconised kraft paper 80µm |
| | | Release Value | 12cN/50mm |

| **Adhesive (B)** | | Material | Acrylic adhesive |
|---|---|---|---|
| | | Thickness | 50µm |
| | | Adhesion | >33.5kg/m |
| | | Insulation Resistance | 3.4 × ×10¹⁴ ohms |
| | | Contact Resistance | <0.3 ohms |
| | | Current Capacity | 1A/in² |
| | | Dimensions (a) | 6.0mm |
| | | Dimensions (b) | 4.0mm |
| | | Dimensions (c) | 3.0mm |
| | Release Liner | Material | Siliconised kraft paper |
| | | Thickness | 100µm |

As can be seen, the busbar 1 of the invention may be provided with a non-conductive adhesive (adhesive A) or an electrically conductive adhesive (adhesive B). In either case the adhesive 3 is applied so as not to overhang the edge of the substrate 2. In the above table, three substrate widths and three corresponding adhesive widths are disclosed. However, it should be appreciated that the busbar 1 could be of any width, for example the substrate 2 could be 4, 5, 6, 7, 8, 9, 10, 11, 12 mm wide, preferably with a tolerance of ±0.1mm or better.

In each case, the adhesive material 3 will be appropriately sized so that, with the adhesive applied symmetrically at and about a longitudinal centre line of the or a major surface 2a of the substrate 2 the adhesive does not overlie the edge of the major surface 2a.

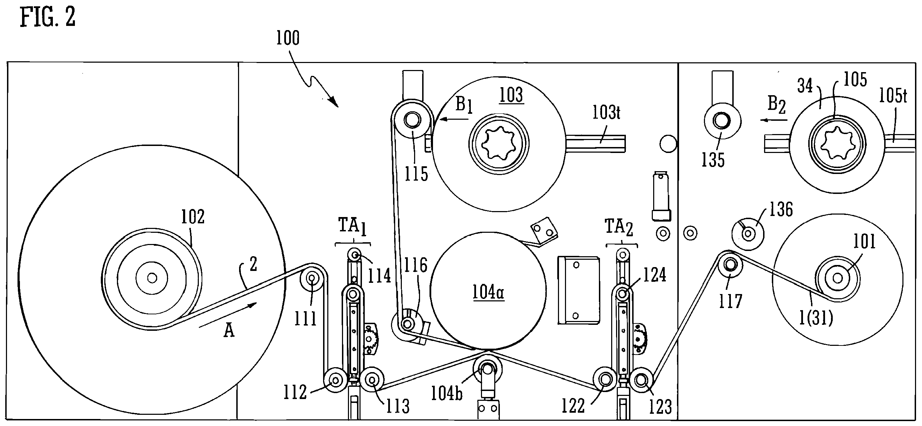

In order to apply the adhesive 3 it is convenient to use the apparatus 100 shown in Figure 2, which is a reel-to-reel continuous apparatus in which busbar 1 is collected on a busbar collection reel 101.

In the apparatus 100 conductive material 2 is continuously supplied from a conductive material reel 102 in the direction of arrow A (the flow direction) whilst adhesive material 3 is supplied from an adhesive material reel 103. The two are brought together at an application station 104 and collected on the busbar collection reel 101.

In use, busbar substrate material 2 is supplied wound onto the reel 102 which is mounted on a spindle arranged to drivably rotate the reel 102 in an anti-clockwise direction to deliver substrate material 2 in the direction of arrow A. The substrate material 2 runs over a delivery roll 111, and into first tensioning apparatus TA₁ comprising first and second tensioning rolls 112, 113 and tensioning dancer 114. The vertical distance between the first and second tensioning rolls 112, 113 and the tensioning dancer 114 is adjustable to ensure and maintain a known tension in the substrate material 2. After exiting the first tensioning apparatus TA₁ the substrate is directed to the application station 104 where it is brought into contact with adhesive material 3 delivered from the adhesive supply reel 103.

The adhesive material 3 is provided on the adhesive supply reel 103 which is freely rotatable and rotates clockwise to allow adhesive material 3 backed with a release liner 3a to be drawn from the reel 103. The reel 103 is biased in the direction of arrow B₁ such that the adhesive material 3 contacts a roller 115. The adhesive material 3 is directed over the roller 115 (which is freely rotatable in an anti-clockwise direction) and under a second roll 116 whereupon it is brought into contact with the substrate material 2 at the application station 104.

The roller 115 may be provided, on its working surface, with a friction imparting surface, preferably comprising a plurality of raised islands fabricated, for example, from silicone rubber. This helps to grip the adhesive material 3, specifically the release liner of the adhesive material which contacts the roller 115 and helps to ensure accurate location of the adhesive material 3 on the conductive material 1. Indeed, our experiments show that the biasing of the roll 103 to ensure contact of the adhesive material 3 with the roller 115 significantly helps with the accurate positioning of the adhesive material 3 on the conductive material 1 at the run speeds needed for commercial reel-to-reel manufacture. It is most preferred that the biasing effect is coupled with a substantially vertical direction of travel of adhesive material 3 between rollers 115 and 116 to effect the most accurate location of adhesive material 3 at or about the centre line of the major face of the conductive material 2.

The biasing effect in the direction of arrow B₁ may be provided by angling the track 103t on which the roll 103 is mounted away from the horizontal such that the weight of the roll 103 causes continual contact between the adhesive material 3 and the roller 115 (our experiments show that an angle of 3 to 15°, preferably 4 to 10, such as 5° is appropriate) and/or by suspending a freely-hanging weight from an elongate member, eg a length of cord attached to the roll 103 in a direction other than directly below the roll 103 so as to pull the roll 103 towards the roller 115 to ensure that the adhesive material 3 held on the roll 103 abuts and engages the roller 115.

The application station 104 comprises a first application roller 104a and a second application roller 104b having a nip therebetween into which the substrate material 2 and adhesive material 3 are introduced to force the adhesive material 3 into contact with the major surface 2a of the substrate material 2, thereby to secure the two together. Preferably, the pressure exerted in 3 bar but it could be from 1 to 5 bar, or otherwise, depending on the adhesive, run speed and so on. One or other of the first application roller 104a and second application roller 104b are preferably heated to improve the strength of the bond between the adhesive material 3 and the substrate 2. In a preferred embodiment the first roller 104a is heated to a maximum temperature of 60-70°C to facilitate the bonding.

The so-formed busbar material 1 is directed to the second tensioning apparatus TA₂ comprising first and second tensioning rolls 122, 123 and tensioning dancer 124. The vertical distance between the first and second tensioning rolls 122, 123 and the tensioning dancer 124 is adjusted and/or adjustable to ensure and maintain a known tension in the busbar material 1.

After exiting the second tensioning apparatus TA₂ the busbar material 1 runs over a roller 117 from where it is wound onto busbar collection reel 101 which is rotatably driven anti-clockwise.

By carefully driving the reels 101, 102, 104a and controlling the tension in the supplied material, it is possible to run the apparatus 100 at a linear speed of 500mm/s or faster, thereby ensuring that the apparatus 100 is capable of producing significant lengths of adhesive busbar material 1 during a working day. Indeed, in an eight hour shift it is possible to manufacture over 10km of busbar 1 using the apparatus 100 of the invention.

### Example 1

Using the apparatus 100 of Figure 2, continuous adhesive backed busbar material 1 was fabricated.

The substrate material was tinned copper with dimensions 8±0.1mm × 0.05mm±5%.

The adhesive was a pressure sensitive acrylic adhesive tape with a thickness of 50µm provided with an 80µm siliconised paper release liner. The adhesive had a width of 6mm. The adhesive was applied symmetrically along the longitudinal centre line of the major surface 2a of the substrate 2.

The degree of variation along a 10m length of busbar 1 in the position of the adhesive 3 was less than 1%.

The so-formed busbar 1 was used to provide an electrical connection within an automotive windscreen. To do so the release liner 3a is removed and the adhesive 3 used to secure the busbar 1 to the desired location. Because of the position of the adhesive 3 there was no issue with balling or other imperfections in the finished assembly.

### Example 2

Using the apparatus 100 of Figure 2, continuous conductive adhesive backed busbar material 1 was fabricated.

The substrate material was tinned copper with dimensions 6±0.1mm × 0.05mm±5%.

The conductive adhesive was a pressure sensitive acrylic adhesive tape with a thickness of 50µm provided with a 100µm siliconised paper release liner. The adhesive had a width of 4mm.

The adhesive was applied symmetrically along the longitudinal centre line of the major surface 2a of the substrate 2.

The degree of variation along a 10m length of busbar 1 in the position of the adhesive 3 was again less than 1%.

The so-formed busbar 1 was used to provide an electrical connection within an automotive windscreen. To do so the release liner 3a is removed and the adhesive 3 used to secure the busbar 1 to the desired location. The conductive adhesive enables electrical connection to the busbar 1 to be made through the adhesive and because of the electrical anisotropy there is no risk of shorting the so-formed circuit.

Because of the position of the adhesive 3 there was no issue with balling or other imperfections in the finished assembly.

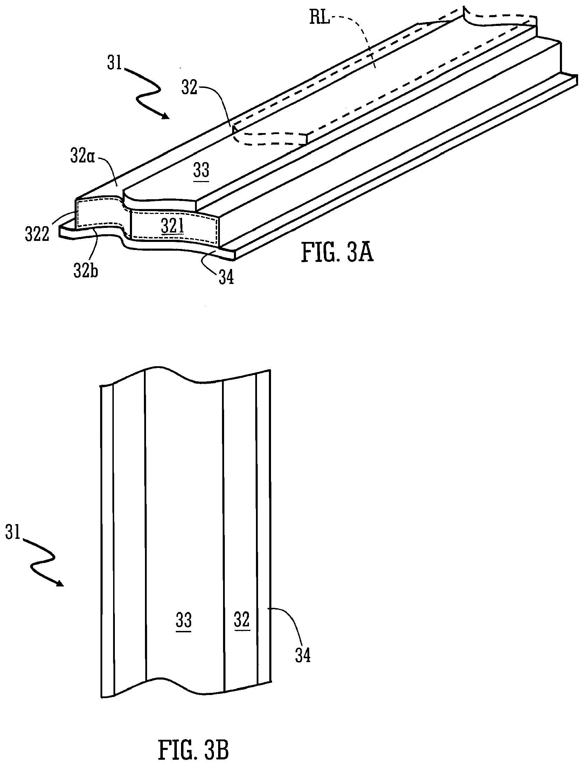

Referring to Figures 3A and 3B, there is shown a second busbar 31 according to the invention. The busbar 31 comprises a substrate of coated copper 32 with a length of adhesive material 33 secured to a first major surface 32a. In contact with and across a second major surface 32b is a cover layer 34.

The adhesive material 33 is a strip of adhesive and has a rectangular configuration.

In brief, the substrate of coated copper 32 comprises a rectangular copper strip 31, typically provided with dimensions 12 × 0.5 mm, 8 × 0.5 mm, 6 × 0.5 mm or 4 × 0.5mm, which is coated with a very thin (*e.g.* from 1 to 4 micron) tin layer 322. Typically the tin layer 322 is provided by electroplating, but may also be provided by dip-coating, spraying, painting and so on.

To one major surface 32a of the substrate 32 is secured a length of adhesive material 33, which preferably comprises an acrylic adhesive. The adhesive material 33 is preferably secured to the substrate 32 by localised pressure and/or heating.

The adhesive layer 33 may be protected by an optional release liner RL.

The adhesive layer 33 is preferably applied at and about a mid-point of the first major surface 32a and terminates inboard of the edges of the substrate 32, preferably by more than 0.5mm.

Applied to the second major surface 32b of the substrate 33 is a cover layer 34. As shown, the cover layer 34 is wider than the substrate 32 such that it protrudes, preferably symmetrically, beyond either lateral edge of the substrate 32. Typically the cover layer 34 will overhang the substrate by from 0.5 to 5mm, preferable from 1 to 3 mm. However in some embodiments the cover layer 34 will be the same size or smaller than the substrate 21.

The cover layer 34 may be formed from a plastics material and may be provided to protect the second major surface 32b of the substrate 32. In one embodiment the cover layer 34 is an adhesive-coated plastics material, the adhesive being located on the substrate facing side of the cover layer 34 to adhere the cover layer to the substrate 32. In other embodiments the cover layer 34 does not have an adhesive.

If present, and where the cover layer 34 has a transverse dimension greater than that of the substrate 32, the adhesive on the cover layer 34 may help to secure the edges of the busbar 31 *in situ* at a site of use. The adhesive may help to prevent or reduce the possibility of ingress of dirt, humidity and so on during or after installation of the busbar 31. In some embodiments the cover layer 34 (usually of the non-adhesive variety) may be removed from the busbar 31 prior to or after installation at a site of use.

When it remains *in situ* the cover layer 34 may be appropriately coloured (often black) to help mask the presence of the busbar 31 at a site of use.

The characteristics of the so-formed busbar 31 are as follows:

**Table 2 Material Characteristics**

| **Substrate** | | Material | Cu (C101) |
|---|---|---|---|
| | | Dimensions (a) | 12±0.6mm × 0.05mm±0.5% |
| | | Dimensions (b) | 8.0±0.4mm × 0.05mm±0.5% |
| | | Dimensions (c) | 6.0±0.3mm × 0.05mm±0.5% |
| | | Dimensions (d) | 4.0±0.2mm × 0.05mm±0.5% |
| | Coating | As per Table 1 | |
| **Adhesive (A)** | | As per Table 1 | |
| **Adhesive (B)** | | As per Table 1 | |
| **Cover Layer (A)** | | Material | Black PET |
| | | Thickness | 0.01 to 0.03 mm |
| | | Adhesive | Acrylic |
| | | Peel Strength (180°N/20mm) | 3-10.8 |
| **Cover Layer (B)** | | Material | White siliconised paper 0.05 to 0.08 mm |

As described above in relation to the first busbar 1, the busbar 31 of the invention may be provided with a non-conductive adhesive (adhesive A) or an electrically conductive adhesive (adhesive B). In either case the adhesive 33 is applied so as not to overhang the edge of the substrate 32. In the above table, four substrate widths, two adhesive widths and two cover layer 34 widths and materials are disclosed. However, it should be appreciated that the busbar 31 could be of any width, for example the substrate 32 could be 4, 5, 6, 7, 8, 9, 10, 11, 12 mm wide, preferably with a tolerance in the longitudinal direction of ±0.1mm or better.

In each case, the adhesive material 33 will be appropriately sized so that, with the adhesive applied symmetrically at and about a longitudinal centre line of the or a major surface 32a of the substrate 32 the adhesive does not overlie the edge of the major surface 32a.

Supplying the adhesive material 32 from a reel ensures that the adhesive 32 is dimensionally invariant and positionally invariant and makes it easier and more consistent to apply than a wet method.

The busbar 31 may be conveniently manufactured using the apparatus 100 of Figure 2, as set out in the corresponding description above. However, in this case, cover layer material 34 may be supplied from a cover layer material supply reel 105. The supply reel 105 is freely rotatable and is biased in the direction of arrow B₂, preferably in a manner as set out above in relation to roll 103, so as to cause the cover material 34 provided on the reel 105 to contact the reel 135. The reel 135 may be covered, on its working surface, with a friction imparting surface, as set out in relation to roll 115, to aid with gripping of the cover material 34. The cover layer material 34 is then brought into contact with the free major surface of the substrate 32 by way of an application station (not shown).

Preferably the application is upstream of the reel 101. Alternatively, busbar 31 dispensed from the reel 101 may be contacted with cover material 34 at the application station and then re-collected onto a further reel (not shown).

The cover layer material 34 may be adhesively bonded to the busbar material 31 and/or may be pressed against the busbar material 31 in the nip between counteracting application rollers (not shown). The busbar material 31 is subsequently collected on the busbar collection reel 101, or on a further reel, as set out in the corresponding description above. If the cover material 34 is sufficiently non adherent to the adhesive layer 3 the optional release liner may be dispensed with.

## Claims

1. A continuous method of forming a busbar, (1,31) the method comprising continuously providing an electrically conductive material (2,32) having a first major surface (2a,32a) with longitudinal edges, continuously bringing an adhesive material (3,33) into contact with the electrically conductive material (2,32) and securing the adhesive material (3,33) to the first major surface (2a,32a) of the electrically conductive material (2,32) such that the adhesive material (3,33) is inboard of both of the longitudinal edges of the first major surface (2a,32a) of the electrically conductive material (2,32) and is able subsequently to secure the first major surface (2a,32a) of the busbar (1,31) at a site of use.

2. A method according to Claim 1, comprising forming the busbar (1,31) at a rate in excess of 400mm/s, preferably at a rate in excess of 410, 420, 430, 440, 450, 460, 470, 480, 490 or 500 mm/s.

3. A method according to Claim 1 or 2, comprising securing the adhesive material (3,33) to the electrically conductive material (2,32) inboard of the longitudinal edges of the first major surface (2a,32a) of the electrically conductive material, (2,32) so as to provide a border extending at least 0.5mm inboard of the or each longitudinal edge.

4. A method according to any preceding Claim, comprising securing a cover layer to a second major surface (32b) of the electrically conductive material. (2,32)

5. A method according to Claim 4, comprising securing the cover layer such that it overhangs each longitudinal edge of the second major surface. (32b)

6. A busbar (1, 31) for installation on or in a structure, the busbar (1, 31) comprising a length of electrically conductive material (2, 32) having a, preferably dimensionally invariant, adhesive material (3, 33) secured along a first major surface (2a, 32a) along the length thereof and is able to secure the first major surface of the electrically conductive material of the busbar (1, 31) at a site of use, **characterised in that** the adhesive material (3, 33) is inboard of both of the longitudinal edges of the first major surface of the electrically conductive material (2, 32).

7. A busbar (1, 31) according to Claim 6, wherein the electrically conductive material (2, 32) comprises an electrically conductive substrate (21, 321) provided with a protective coating (22, 322).

8. A busbar (1, 31) according to any of Claims 6 or 7, wherein the adhesive material (3, 33) comprises a carrier substrate with a pair of major surfaces, each of which carry adhesive.

9. A busbar (1, 31) according to any of Claims 6, 7 or 8, wherein the adhesive material (3, 33) is electrically conductive or non-electrically conductive.

10. A busbar (1, 31) according to Claim 9, wherein the adhesive material (3, 33) is electrically conductive and wherein the electrically conductive adhesive material (3, 33) is conductive in one or two planes but not a third, or in one plane but not the other two.

11. A busbar (1, 31) according to any of Claims 6 to 10, wherein the adhesive material (3, 33) covers more than 25% of the surface area of one side of the electrically conductive material (2, 32), for example more than, 30, 35, 40, 45, 50, 55, 60, 65, 70, 75, 80, 85, 90, 95% of the surface area of the conductive material (2, 32).

12. A busbar (1, 31) according to any of Claims 6 to 11, wherein the adhesive material (3, 33) is less than 150 µm thick, for example less than 100, 95, 90, 85, 80, 75, 70, 65, 60 or 55 µm thick.

13. A busbar (1, 31) according to any of the Claims 6 to 12, comprising a cover layer (34) on the obverse face to that of the adhesive layer (3, 33) and preferably is less than 50 × 10⁻⁶m thick.

14. An apparatus (100) for continuously forming a busbar (1, 31), the apparatus comprising means (102) to supply a length of conductive material (2, 32), means (103) to supply an adhesive material (3, 33), means (104a, 104b, 111, 112, 113, 114, 115, 116) to bring adhesive material (3, 33) into contact with a first major surface (2a, 32a) of the length of conductive material (2, 32), means (104a, 104b) to heat and or press the adhesive material (3, 33) at the point of contact to the conductive material (2, 32) thereby to secure the adhesive material (3, 33) along the length of the conductive material (2, 32) and inboard of both of the longitudinal edges of the first major surface of the conductive material (2, 32) to thereby form a busbar (1, 31), where the adhesive material (3, 33) is able subsequently to secure the first major surface of the busbar (1, 31) at a site of use.

## Patentansprüche

1. Kontinuierliches Verfahren zum Bilden einer Sammelschiene (1,31), wobei das Verfahren das kontinuierliche Bereitstellen eines elektrisch leitenden Materials (2,32), das eine erste Hauptoberfläche (2a,32a) mit Längskanten aufweist, das kontinuierliche Inkontaktbringen eines Klebstoffmaterials (3,33) mit dem elektrisch leitenden Material (2,32) und das Befestigen des Klebstoffmaterials (3,33) an der ersten Hauptoberfläche (2a,32a) des elektrisch leitenden Materials (2,32) umfasst, sodass sich das Klebstoffmaterial (3,33) innerhalb beider Längskanten der ersten Hauptoberfläche (2a,32a) des elektrisch leitenden Materials (2,32) befindet und anschließend in der Lage ist, die erste Hauptoberfläche (2a,32a) der Sammelschiene (1,31) an einem Verwendungsort zu befestigen.

2. Verfahren nach Anspruch 1, umfassend das Bilden der Sammelschiene (1,31) bei einer Rate von mehr als 400 mm/s, bevorzugt bei einer Rate von mehr als 410, 420, 430, 440, 450, 460, 470, 480, 490 oder 500 mm/s.

3. Verfahren nach Anspruch 1 oder 2, umfassend das Befestigen des Klebstoffmaterials (3,33) an dem elektrisch leitenden Material (2,32) innerhalb der Längskanten der ersten Hauptoberfläche (2a,32a) des elektrisch leitenden Materials (2,32), um einen Rand bereitzustellen, der sich zumindest 0,5 mm innerhalb der oder jeder Längskante erstreckt.

4. Verfahren nach einem vorhergehenden Anspruch, umfassend das Befestigen einer Deckschicht an einer zweiten Hauptoberfläche (32b) des elektrisch leitenden Materials (2,32).

5. Verfahren nach Anspruch 4, umfassend das Befestigen der Deckschicht, sodass sie über jede Längskante der zweiten Hauptoberfläche (32b) hinausragt.

6. Sammelschiene (1, 31) zur Installation an oder in einer Struktur, wobei die Sammelschiene (1, 31) eine Länge an elektrisch leitendem Material (2, 32) umfasst, das ein bevorzugt dimensional unveränderliches Klebstoffmaterial (3, 33) aufweist, das entlang einer ersten Hauptoberfläche (2a, 32a) entlang der Länge davon befestigt ist und in der Lage ist, die erste Hauptoberfläche des elektrisch leitenden Materials der Sammelschiene (1, 31) an einem Verwendungsort zu befestigen, **dadurch gekennzeichnet, dass** sich das Klebstoffmaterial (3, 33) innerhalb beider Längskanten der ersten Hauptoberfläche des elektrisch leitenden Materials (2, 32) befindet.

7. Sammelschiene (1, 31) nach Anspruch 6, wobei das elektrisch leitende Material (2, 32) ein elektrisch leitendes Substrat (21, 321) umfasst, das mit einer Schutzbeschichtung (22, 322) bereitgestellt ist.

8. Sammelschiene (1, 31) nach einem der Ansprüche 6 oder 7, wobei das Klebstoffmaterial (3, 33) ein Trägersubstrat mit einem Paar Hauptoberflächen umfasst, von denen jede Klebstoff trägt.

9. Sammelschiene (1, 31) nach einem der Ansprüche 6, 7 oder 8, wobei das Klebstoffmaterial (3, 33) elektrisch leitend oder nicht elektrisch leitend ist.

10. Sammelschiene (1, 31) nach Anspruch 9, wobei das Klebstoffmaterial (3, 33) elektrisch leitend ist und wobei das elektrisch leitende Klebstoffmaterial (3, 33) in einer oder zwei Ebenen leitend ist, aber nicht einer dritten, oder in einer Ebene, aber nicht den anderen zwei.

11. Sammelschiene (1, 31) nach einem der Ansprüche 6 bis 10, wobei das Klebstoffmaterial (3, 33) mehr als 25 % des Oberflächenbereichs einer Seite des elektrisch leitenden Materials (2, 32) bedeckt, zum Beispiel mehr als 30, 35, 40, 45, 50, 55, 60, 65, 70, 75, 80, 85, 90, 95 % des Oberflächenbereichs des leitenden Materials (2, 32).

12. Sammelschiene (1, 31) nach einem der Ansprüche 6 bis 11, wobei das Klebstoffmaterial (3, 33) weniger als 150 µm dick ist, zum Beispiel weniger als 100, 95, 90, 85, 80, 75, 70, 65, 60 oder 55 µm dick.

13. Sammelschiene (1, 31) nach einem der Ansprüche 6 bis 12, umfassend eine Deckschicht (34) auf der Vorderseite zu derjenigen der Klebstoffschicht (3, 33) und bevorzugt weniger als 50 × 10⁻⁶ m dick ist.

14. Vorrichtung (100) zum kontinuierlichen Bilden einer Sammelschiene (1, 31), wobei die Vorrichtung Mittel (102) zum Zuführen einer Länge von leitendem Material (2, 32), Mittel (103) zum Zuführen eines Klebstoffmaterials (3, 33), Mittel (104a, 104b, 111, 112, 113, 114, 115, 116) zum Inkontaktbringen von Klebstoffmaterial (3, 33) mit einer ersten Hauptoberfläche (2a, 32a) der Länge an leitendem Material (2, 32), Mittel (104a, 104b) zum Erhitzen und/oder Pressen des Klebstoffmaterials (3, 33) an dem Kontaktpunkt mit dem leitenden Material (2, 32) umfasst, um dadurch das Klebstoffmaterial (3, 33) entlang der Länge des leitenden Materials (2, 32) und innerhalb von beiden Längskanten der ersten Hauptoberfläche des leitenden Materials (2, 32) zu befestigen, um dadurch eine Sammelschiene (1, 31) zu bilden, wobei das Klebstoffmaterial (3, 33) anschließend in der Lage ist, die erste Hauptoberfläche der Sammelschiene (1, 31) an einem Verwendungsort zu befestigen.

## Revendications

1. Procédé continu de formation d'une barre omnibus, (1,31) le procédé comprenant la fourniture en continu d'un matériau électroconducteur (2,32) comportant une première surface principale (2a,32a) avec des bords longitudinaux, l'apport en continu d'un matériau adhésif (3,33) en contact avec le matériau électroconducteur (2,32) et la fixation du matériau adhésif (3,33) à la première surface principale (2a,32a) du matériau électroconducteur (2,32) de sorte que le matériau adhésif (3,33) soit à l'intérieur des deux des bords longitudinaux de la première surface principale (2a,32a) du matériau électroconducteur (2,32) et puisse ensuite fixer la première surface principale (2a,32a) de la barre omnibus (1,31) au niveau d'un site d'utilisation.

2. Procédé selon la revendication 1, comprenant la formation de la barre omnibus (1,31) à une vitesse supérieure à 400 mm/s, de préférence à une vitesse supérieure à 410, 420, 430, 440, 450, 460, 470, 480, 490 ou 500 mm/s.

3. Procédé selon la revendication 1 ou 2, comprenant la fixation du matériau adhésif (3,33) au matériau électroconducteur (2,32) à l'intérieur des bords longitudinaux de la première surface principale (2a,32a) du matériau électroconducteur, (2,32) de façon à fournir une bordure s'étendant sur au moins 0,5 mm à l'intérieur du ou de chaque bord longitudinal.

4. Procédé selon une quelconque revendication précédente, comprenant la fixation d'une couche de couverture sur une seconde surface principale (32b) du matériau électroconducteur (2,32).

5. Procédé selon la revendication 4, comprenant la fixation de la couche de couverture de sorte qu'elle surplombe chaque bord longitudinal de la seconde surface principale (32b).

6. Barre omnibus (1, 31) destinée à être installée sur ou dans une structure, la barre omnibus (1, 31) comprenant une longueur de matériau électroconducteur (2, 32) possédant un matériau adhésif (3, 33) de préférence invariant en dimensions fixé le long d'une première surface principale (2a, 32a) le long de sa longueur et est capable de fixer la première surface principale du matériau électroconducteur de la barre omnibus (1, 31) au niveau d'un site d'utilisation, **caractérisé en ce que** le matériau adhésif (3, 33) est à l'intérieur des deux des bords longitudinaux de la première surface principale du matériau électroconducteur (2, 32).

7. Barre omnibus (1, 31) selon la revendication 6, ledit matériau électroconducteur (2, 32) comprenant un substrat électroconducteur (21, 321) doté d'un revêtement protecteur (22, 322).

8. Barre omnibus (1, 31) selon l'une quelconque des revendications 6 ou 7, ledit matériau adhésif (3, 33) comprenant un substrat porteur avec une paire de surfaces principales, dont chacune porte un adhésif.

9. Barre omnibus (1, 31) selon l'une quelconque des revendications 6, 7 ou 8, ledit matériau adhésif (3, 33) étant électroconducteur ou non électroconducteur.

10. Barre omnibus (1, 31) selon la revendication 9, ledit matériau adhésif (3, 33) étant électroconducteur et ledit matériau adhésif électroconducteur (3, 33) étant conducteur dans un ou deux plans mais pas dans un troisième, ou dans un plan mais pas dans les deux autres.

11. Barre omnibus (1, 31) selon l'une quelconque des revendications 6 à 10, ledit matériau adhésif (3, 33) couvrant plus de 25 % de l'aire d'un côté du matériau électroconducteur (2, 32), par exemple plus de 30, 35, 40, 45, 50, 55, 60, 65, 70, 75, 80, 85, 90, 95 % de l'aire du matériau conducteur (2, 32).

12. Barre omnibus (1, 31) selon l'une quelconque des revendications 6 à 11, ledit matériau adhésif (3, 33) possédant une épaisseur inférieure à 150 µm, par exemple une épaisseur inférieure à 100, 95, 90, 85, 80, 75, 70, 65, 60 ou 55 µm.

13. Barre omnibus (1, 31) selon l'une quelconque des revendications 6 à 12, comprenant une couche de couverture (34) sur la face d'avers à celle de la couche adhésive (3, 33) et possédant de préférence une épaisseur inférieure à 50 × 10⁻⁶ m.

14. Appareil (100) destiné à la formation en continu d'une barre omnibus (1, 31), l'appareil comprenant un moyen (102) pour fournir une longueur de matériau conducteur (2, 32), un moyen (103) pour fournir un matériau adhésif (3, 33), un moyen (104a, 104b, 111, 112, 113, 114, 115, 116) pour amener le matériau adhésif (3, 33) en contact avec une première surface principale (2a, 32a) de la longueur de matériau conducteur (2, 32), un moyen (104a, 104b) pour chauffer et/ou presser le matériau adhésif (3, 33) au niveau du point de contact avec le matériau conducteur (2, 32) pour fixer ainsi le matériau adhésif (3, 33) le long de la longueur du matériau conducteur (2, 32) et à l'intérieur des deux des bords longitudinaux de la première surface principale du matériau conducteur (2, 32) pour former ainsi une barre omnibus (1, 31), où le matériau adhésif (3, 33) est capable de fixer ensuite la première surface principale de la barre omnibus (1, 31) au niveau d'un site d'utilisation.
